(19) Europäisches Patentamt
European Patent Office
Office européen des brevets

(11) **EP 4 085 529 B1**

(12) **FASCICULE DE BREVET EUROPEEN**

(45) Date de publication et mention
de la délivrance du brevet:
**30.04.2025 Bulletin 2025/18**

(21) Numéro de dépôt: **20820154.1**

(22) Date de dépôt: **09.12.2020**

(51) Classification Internationale des Brevets (IPC):
**H03K 17/16** (2006.01)   **H02H 9/00** (2006.01)
**H02J 7/00** (2006.01)   **H02M 1/36** (2007.01)

(52) Classification Coopérative des Brevets (CPC):
**H03K 17/163; H02H 9/001; H02J 7/00304;
H02M 1/36; H02M 3/158;** H02J 7/342;
H02J 2207/50; Y02T 10/70

(86) Numéro de dépôt international:
**PCT/EP2020/085232**

(87) Numéro de publication internationale:
**WO 2021/136635 (08.07.2021 Gazette 2021/27)**

(54) **DISPOSITIF DE PRÉ-CHARGE ET CONVERTISSEUR DE TENSION COMPORTANT UN TEL DISPOSITIF**

VORLADEEINRICHTUNG UND SPANNUNGSWANDLER MIT EINER SOLCHEN VORRICHTUNG

PRECHARGING DEVICE AND VOLTAGE CONVERTER COMPRISING SUCH A DEVICE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **31.12.2019 FR 1915786**

(43) Date de publication de la demande:
**09.11.2022 Bulletin 2022/45**

(73) Titulaire: **Valeo Electrification
95800 Cergy (FR)**

(72) Inventeur: **PLAIDEAU, Michel
95892 CERGY PONTOISE (FR)**

(74) Mandataire: **Valeo Powertrain Systems
Service Propriété Intellectuelle
Immeuble le Delta
14, avenue des Béguines
95892 Cergy Pontoise (FR)**

(56) Documents cités:
**EP-A1- 3 226 395   EP-A1- 3 421 287
FR-A1- 2 984 623   US-A1- 2018 316 279**

**Description**

DOMAINE TECHNIQUE

La présente invention concerne de manière générale un dispositif de pré-charge d'une charge et un convertisseur de tension comprenant un tel dispositif de pré-charge.

ARRIÈRE-PLAN TECHNOLOGIQUE

Les véhicules électriques ou hybrides sont équipés d'un convertisseur de tension continu/continu dit convertisseur de tension DC/DC (DC étant les initiales de "direct current", ou "courant continu"). Ce convertisseur de tension est destiné à être embarqué dans un véhicule afin de réaliser une conversion de tension entre un premier réseau électrique et un deuxième réseau électrique du véhicule. Typiquement, le premier réseau électrique est un réseau basse tension délivrant une tension inférieure à 30V, par exemple de 24V, de 14V ou encore de 12V, et le deuxième réseau électrique est un réseau haute tension qui délivre une tension supérieure à 30V, par exemple de 48V.Un problème connu est celui de la charge initiale du deuxième réseau électrique ayant la tension nominale la plus élevée par l'autre réseau jusqu'à la tension nominale de ce dernier.

Le document US 2018/316279 décrit un dispositif de pré-charge selon l'art antérieur.

Ce problème technique est particulièrement difficile à résoudre quand il s'agit de charger un réseau de bord ayant une tension nominale d'au moins 48V et comprenant des condensateurs de forte valeur, par exemple de l'ordre de quelques dizaines de mF, à partir d'un réseau de 14V par exemple, car un appel de courant initial très important, de l'ordre de 400 A ou plus peut se produire.

Il convient donc lors de la charge du réseau ayant la tension nominale la plus élevée de limiter ce courant initial afin de ne dégrader ni les composants de ce réseau, ni les composants du convertisseur de tension lui-même.

Pour ce faire, il est connu de l'état de la technique, notamment du document FR 2984623, un dispositif de pré-charge pour charger une charge à partir d'une unité de stockage d'énergie électrique comprenant un premier transistor apte à connecter directement la charge à l'unité de stockage d'énergie électrique et un second transistor apte à connecter la charge à l'unité de stockage d'énergie électrique avec un effet de limitation du courant électrique pouvant circuler entre l'unité de stockage d'énergie électrique et la charge, caractérisé en ce que le second transistor comporte un transistor commandé en régime linéaire pendant une temporisation de durée prédéterminée et en ce que le dispositif de pré-charge comprend un circuit de commande muni d'une boucle d'asservissement de courant pour la commande en régime linéaire du transistor du second transistor.

La mise en œuvre de ce type de dispositif de pré-charge nécessite la mise en œuvre d'une boucle d'asservissement complexe.

L'invention a pour but de pallier au moins en partie à cet inconvénient.

RÉSUMÉ DE L'INVENTION

A cet effet, il est proposé, selon un premier aspect de l'invention, un dispositif de pré-charge d'une charge, par exemple d'une capacité, selon la revendication 1.

Ce dispositif de pré-charge est remarquable en ce qu'il comprend un circuit de démarrage conçu pour maintenir le courant de pré-charge constant en faisant monter progressivement la tension de la borne de commande du premier transistor de pré-charge de sorte que celui-ci se ferme progressivement. Ainsi, par rapport à l'art antérieure, le dispositif de pré-charge selon l'invention régule le courant de pré-charge initial sans recourir à une boucle d'asservissement complexe.

Le dispositif de pré-charge selon le premier aspect de l'invention peut également présenter une ou plusieurs des caractéristiques des modes particuliers de réalisation ci-dessous, considérées individuellement ou selon toutes les combinaisons techniquement possibles.

Dans un mode de réalisation particulier de l'invention, le premier transistor de pré-charge est un transistor de type FET (de l'anglais « Field-Effect Transistor ») ou de type IGBT (de l'anglais « Insulated-Gate Bipolar Transistor »).

Dans un mode de réalisation particulier de l'invention, le premier transistor de pré-charge de type FET est un MOSFET en silicium (Si-MOSFET) ou en carbure de silicium (SiC-MOSFET) ou est un transistor FET en nitrure de gallium (GaN-FET).

Lorsque le premier transistor de pré-charge est un MOSFET, par exemple un MOSFET à déplétion de type N, son « drain », sa « source » et sa « grille » constitue respectivement la « première borne », la « deuxième borne » et la « borne de commande ».

Dans un mode de réalisation particulier de l'invention, le premier transistor de pré-charge est un transistor HEMT (de l'anglais « high-electron-mobility transistor ») par exemple en nitrure de gallium.

Dans un mode de réalisation particulier de l'invention, le premier interrupteur est un transistor bipolaire, par exemple un transistors bipolaire pnp présentant une base formant la borne de commande, et un émetteur et un collecteur formant respectivement la première borne et la deuxième borne.

Dans un mode de réalisation particulier de l'invention, le dispositif de pré-charge comprend en outre une première résistance et la borne de commande du premier interrupteur est directement connectée à la masse électrique par l'intermédiaire de l'association en série de la première capacité C1 et de la première résistance.

Dans un mode de réalisation particulier de l'invention, la première résistance est connectée par une de ses bornes à la première capacité et par l'autre de ses bornes à la masse électrique.

Dans un mode de réalisation particulier de l'invention, la première capacité est connectée par une de ses bornes à la première résistance et par l'autre de ses bornes à la borne de commande du premier interrupteur.

Dans un mode de réalisation particulier de l'invention, la source de courant comprend :

a) une deuxième, une troisième et une quatrième résistance,

b) une deuxième source de tension continue,

c) un deuxième interrupteur comprenant :

i) une borne de commande destinée à sélectivement ouvrir ou fermer ledit deuxième interrupteur sur réception d'un signal de commande,

ii) une première borne connectée à la deuxième source de tension par l'intermédiaire de ladite deuxième résistance,

iii) une deuxième borne connectée à la borne de commande du premier interrupteur,

d) un troisième interrupteur comprenant :

i) une borne de commande destinée à recevoir un signal de commande permettant la commutation à l'ouverture ou à la fermeture du troisième interrupteur,

ii) une deuxième borne connectée à la masse électrique par l'intermédiaire de la quatrième résistance,

iii) une première borne connectée à la borne de commande du deuxième interrupteur et connectée à la deuxième source de tension par l'intermédiaire de la troisième résistance.

Dans un mode de réalisation particulier de l'invention, la tension délivrée par la deuxième source de tension continue est supérieure à la tension délivrée par la première source de tension continue.

Dans un mode de réalisation particulier de l'invention, le deuxième interrupteur est un transistor bipolaire, par exemple un transistors bipolaire pnp présentant une base formant la borne de commande, et un émetteur et un collecteur formant respectivement la première borne et la deuxième borne.

Dans un mode de réalisation particulier de l'invention, le troisième interrupteur est un transistor bipolaire, par exemple un transistors bipolaire npn présentant une base formant la borne de commande, et un émetteur et un collecteur formant respectivement la deuxième borne et la première borne.

Dans un mode de réalisation particulier de l'invention, le dispositif de pré-charge comprend en outre un interrupteur de dérivation comprenant :

a) une borne de commande destinée à sélectivement ouvrir ou fermé ledit interrupteur de dérivation sur réception d'un signal de commande,

b) une deuxième borne connectée à ladite masse électrique, et

c) une première borne connectée à ladite borne d'alimentation.

Dans un mode de réalisation particulier de l'invention, l'interrupteur de dérivation est un transistor de type FET (de l'anglais « Field-Effect Transistor ») ou de type IGBT (de l'anglais « Insulated-Gate Bipolar Transistor »).

Dans un mode de réalisation particulier de l'invention, l'interrupteur de dérivation est un MOSFET en silicium (Si-MOSFET) ou en carbure de silicium (SiC-MOSFET).

Lorsque l'interrupteur de dérivation est un MOSFET, par exemple un MOSFET à déplétion de type N, son « drain », sa « source » et sa « grille » constitue respectivement la « première borne », la « deuxième borne » et la « borne de commande ».

Dans un mode de réalisation particulier de l'invention, l'interrupteur de dérivation est un transistor FET en nitrure de gallium (GaN-FET).

Dans un mode de réalisation particulier de l'invention, l'interrupteur de dérivation est un transistor HEMT (de l'anglais « high-electron-mobility transistor ») par exemple en nitrure de gallium.

Dans un mode de réalisation particulier de l'invention, la charge est une deuxième capacité et le quotient de l'intensité du courant de charge constant fourni par la source de courant par le courant de pré-charge est égal au quotient de la valeur de la première capacité par la valeur de la deuxième capacité.

Dans un mode de réalisation particulier de l'invention, le dispositif de pré-charge comprend en outre une diode Zener dont la cathode est connectée électriquement à la borne de commande du premier transistor de pré-charge et dont l'anode est connectée électriquement à la deuxième borne du premier transistor de pré-charge.

Dans un mode de réalisation particulier de l'invention, le dispositif de pré-charge comprend en outre un deuxième transistor de pré-charge comprenant :

a) une deuxième borne connectée à la deuxième borne du premier transistor de pré-charge,

b) une première borne destinée à être connectée électriquement à la charge,

c) une borne de commande destinée à sélectivement ouvrir ou fermer le deuxième transistor de pré-charge et connectée à la borne d'alimentation,

les premier et deuxième transistors de pré-charge comprenant chacun une diode intrinsèque, l'anode de la diode intrinsèque de chaque transistor de pré-charge étant connectée électriquement à la deuxième borne de son transistor de pré-charge.

Dans un mode de réalisation particulier de l'invention, le deuxième transistor de pré-charge est un transistor de type FET (de l'anglais « Field-Effect Transistor ») ou de type IGBT (de l'anglais « Insulated-Gate Bipolar Transistor »).

Dans un mode de réalisation particulier de l'invention, le deuxième transistor de pré-charge de type FET est un MOSFET en silicium (Si-MOSFET) ou en carbure de silicium (SiC-MOSFET) ou est un transistor FET en nitrure de gallium (GaN-FET).

Lorsque le deuxième transistor de pré-charge est un MOSFET, par exemple un MOSFET à déplétion de type N, son « drain », sa « source » et sa « grille » constitue respectivement la « première borne », la « deuxième borne » et la « borne de commande ».

Dans un mode de réalisation particulier de l'invention, le deuxième transistor de pré-charge est un transistor HEMT (de l'anglais « high-electron-mobility transistor ») par exemple en nitrure de gallium.

L'invention vise également, selon un deuxième aspect, un convertisseur de tension comportant au moins un dispositif de pré-charge selon le premier aspect de l'invention.

Le convertisseur de tension selon le deuxième aspect de l'invention peut également présenter une ou plusieurs des caractéristiques des modes particuliers de réalisation ci-dessous, considérées individuellement ou selon toutes les combinaisons techniquement possibles.

Dans un mode particulier de réalisation de l'invention, le convertisseur de tension ne comprend qu'un seul dispositif de pré-charge selon le premier aspect de l'invention.

Dans un mode particulier de réalisation de l'invention, le convertisseur de tension comprend en outre la charge.

Dans un mode particulier de réalisation de l'invention, la charge est une deuxième capacité.

Dans un mode particulier de réalisation de l'invention, le convertisseur de tension est un convertisseur de tension DC/DC.

Dans un mode particulier de réalisation de l'invention, le convertisseur de tension comprend en outre un premier hacheur comportant :

a) une première borne d'entrée connectée électriquement à la deuxième borne du premier transistor de pré-charge, et

b) une deuxième borne de sortie destinée à être connectée à ladite charge.

c) Dans un mode particulier de réalisation de l'invention, la deuxième borne de sortie est également destinée à être connectée à une troisième source de tension continue, ledit convertisseur de tension réalisant la conversion entre les tensions de la première et de la troisième source de tension continue.

Dans un mode particulier de réalisation de l'invention, le premier hacheur comprend une première inductance, un premier et un deuxième interrupteur dits de hachage, chacun desdits interrupteurs de hachage dudit premier hacheur comprend des première et deuxième bornes et une borne de commande destinée à sélectivement ouvrir et fermer l'interrupteur de hachage en fonction d'un signal de commande appliqué sur ladite borne de commande, la première borne du premier interrupteur de hachage étant connectée à la première borne de sortie du premier hacheur, la deuxième borne du premier interrupteur de hachage étant connecté à la première borne du deuxième interrupteur de hachage, la deuxième borne du deuxième interrupteur de hachage étant connectée à la masse électrique, la première inductance étant connectée par une de ses bornes à la première borne du deuxième interrupteur de hachage et par l'autre de ses bornes à la première borne d'entrée du premier hacheur.

Dans un mode de réalisation particulier de l'invention, le premier et le deuxième interrupteur de hachage sont des transistors de type FET (de l'anglais « Field-Effect Transistor ») ou de type IGBT (de l'anglais « Insulated-Gate Bipolar Transistor »).

Dans un mode de réalisation particulier de l'invention, le premier et le deuxième interrupteur de hachage sont des MOSFET en silicium (Si-MOSFET) ou en carbure de silicium (SiC-MOSFET).

Lorsque le premier et le deuxième interrupteur de hachage sont des MOSFETs, par exemple des MOSFETs à déplétion de type N, leur « drain », leur « source » et leur « grille » constitue respectivement la « première borne », la « deuxième borne » et la « borne de commande ».

Dans un mode de réalisation particulier de l'invention, le premier et le deuxième interrupteur de hachage sont des transistors FET en nitrure de gallium (GaN-FET).

Dans un mode de réalisation particulier de l'invention, le premier et le deuxième interrupteur de hachage sont des transistors HEMT (de l'anglais « high-electron-mobility transistor ») par exemple en nitrure de gallium.

Dans un mode de réalisation particulier de l'invention, le convertisseur de tension comprend en outre :

a) un premier transistor de sécurité comprenant une première et une deuxième borne, la première borne étant connectée électriquement à la première borne du premier transistor de précharge, et une borne de commande destinée à sélectivement ouvrir ou fermer ledit premier transistor de sécurité sur réception d'un signal de commande,

b) un deuxième transistor de sécurité comprenant une première et une deuxième borne, la deuxième borne étant connectée à la deuxième borne du premier transistor de sécurité, et une borne de commande destinée à sélectivement ouvrir ou fermer ledit deuxième transistor de sécurité sur réception d'un signal de commande,

c) un deuxième hacheur comportant :

i) une deuxième borne d'entrée connectée électriquement à la première borne du deuxième transistor de sécurité,

ii) une deuxième borne de sortie connectée électriquement à la première borne de sortie dudit premier hacheur.

Dans un mode particulier de réalisation de l'invention, le deuxième hacheur comprend une deuxième inductance, un troisième et un quatrième interrupteur dits de hachage, chacun desdits interrupteurs de hachage dudit deuxième hacheur comprend des première et deuxième bornes et une borne de commande destinée à sélectivement ouvrir et fermer l'interrupteur de hachage en fonction d'un signal de commande appliqué sur ladite borne de commande, la première borne du troisième interrupteur de hachage étant connectée à la deuxième borne de sortie du deuxième hacheur, la deuxième borne du troisième interrupteur de hachage étant connecté à la première borne du quatrième interrupteur de hachage, la deuxième borne du quatrième interrupteur de hachage étant connectée à la masse électrique, la deuxième inductance étant connectée par une de ses bornes à la première borne du quatrième interrupteur de hachage et par l'autre de ses bornes à la deuxième borne d'entrée du deuxième hacheur.

Dans un mode de réalisation particulier de l'invention, le troisième et le quatrième interrupteur de hachage sont des transistors de type FET (de l'anglais « Field-Effect Transistor ») ou de type IGBT (de l'anglais « Insulated-Gate Bipolar Transistor »).

Dans un mode de réalisation particulier de l'invention, le troisième et le quatrième interrupteur de hachage sont des MOSFET en silicium (Si-MOSFET) ou en carbure de silicium (SiC-MOSFET).

Lorsque le troisième et le quatrième interrupteur de hachage sont des MOSFETs, par exemple des MOSFETs à déplétion de type N, leur « drain », leur « source » et leur « grille » constitue respectivement la « première borne », la « deuxième borne » et la « borne de commande ».

Dans un mode de réalisation particulier de l'invention, le troisième et le quatrième interrupteur de hachage sont des transistors FET en nitrure de gallium (GaN-FET).

Dans un mode de réalisation particulier de l'invention, le troisième et le quatrième interrupteur de hachage sont des transistors HEMT (de l'anglais « high-electron-mobility transistor ») par exemple en nitrure de gallium.

Le convertisseur de tension selon le deuxième aspect de l'invention bénéficie des mêmes avantages, cités précédemment, que le dispositif de pré-charge selon le premier aspect de l'invention.

L'invention sera mieux comprise à la lumière de la description qui va suivre, donnée uniquement à titre d'exemple non limitatif et faisant référence aux figures suivantes.

DESCRIPTION DES FIGURES

La [Figure 1] représente un convertisseur de tension et un dispositif de pré-charge conforme à l'invention dans un premier mode de réalisation de l'invention.

La [Figure 2] représente un convertisseur de tension dans un deuxième mode de réalisation de l'invention.

DESCRIPTION DÉTAILLÉE

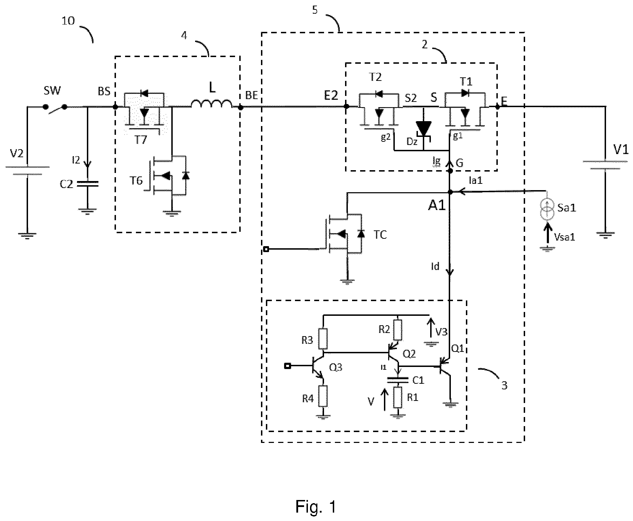

La [Figure 1] représente un convertisseur de tension 10 dans un premier mode de réalisation de l'invention. Ce convertisseur de tension 10 est, dans l'exemple décrit, implémenté dans un véhicule automobile équipé d'un réseau d'alimentation en énergie électrique bitension.

En d'autres termes, le convertisseur de tension 10 est agencé entre les deux réseaux d'alimentation électrique du véhicule automobile.

Dans l'exemple décrit, le premier réseau de bord est un réseau 14V comprenant une première source de tension continue V1, par exemple une première batterie de 14V et le deuxième réseau de bord est un réseau 48V comprenant une deuxième source de tension continue V2, par exemple une deuxième batterie de 48V.

Dans l'exemple décrit ici, les deux sources de tension continue V1 et V2 sont référencées par rapport à une même masse électrique.

Dans l'exemple décrit, le convertisseur de tension 10 comprend:

1. une borne d'entrée E,

2. une borne de sortie BS,

3. un dispositif de commande (non représenté),

4. un hacheur 4, et

5. un dispositif de pré-charge 5.

Le convertisseur de tension 10 est ainsi connecté au premier réseau de bord par sa borne E et au deuxième réseau de bord par sa borne BS.

En d'autres termes, le convertisseur de tension 10 est connectée par l'intermédiaire du premier réseau de bord à la première source de tension V1.

Le deuxième réseau de bord comprend une charge à pré-charger qui est dans l'exemple décrit ici une capacité C2 de l'ordre de 3mF.

Le deuxième réseau de bord comprend également un interrupteur SW, réalisé par exemple sous la forme d'un transistor MOSFET. La deuxième source de tension alimente le deuxième réseau de bord lorsque l'interrupteur SW est fermé. Dans le cas contraire, i.e. lorsque l'interrupteur SW est ouvert, le deuxième réseau de bord n'est pas alimenté par la deuxième source de tension.

En d'autres termes, le convertisseur de tension 10 est connecté par l'intermédiaire du deuxième réseau de bord à la deuxième source de tension V2 lorsque l'interrupteur SW est fermé.

Le hacheur 4 comprend une borne d'entrée BE, une borne de sortie BS (qui est également celle du convertisseur de tension 10), une inductance L, un interrupteur de hachage T6 et un interrupteur de hachage T7.

Le dispositif de pré-charge 5 permet de charger, au travers du hacheur 4 la capacité C2 à partir de la première source de tension V1 en fournissant à la capacité C2 initialement déchargée un courant de pré-charge constant I2 lorsque l'interrupteur SW est ouvert.

Ce dispositif de pré-charge 5 comprend :

• une borne d'alimentation A1 destinée à recevoir un courant d'activation Ia1, ce courant d'activation Ia1 est par

exemple fournie par une source de courant Sa1 faisant partie du dispositif de commande du convertisseur de tension 10,

- un dispositif de sécurité 2,

- un circuit de démarrage 3, et

- un interrupteur de dérivation TC.

Le dispositif de sécurité 2 comprend une première borne E (qui est également la borne d'entrée du convertisseur de tension 10), une deuxième borne E2, une borne de commande G, un premier transistor de pré-charge T1, un deuxième transistor de pré-charge T2 et une diode Zener Dz.

Dans l'exemple décrit, le premier transistor de pré-charge T1 et le deuxième transistor de pré-charge T2 sont de préférence des transistors à effet de champ à structure métal-oxyde-semi-conducteur (de l'anglais « Metal Oxide Semiconductor Field Effect Transistor » ou MOSFET) présentant une grille, un drain et une source.

Chaque interrupteur TC, T6 et T7 comporte une première borne, une deuxième borne et une borne de commande destinée à sélectivement ouvrir et fermer l'interrupteur TC, T6 et T7 en fonction d'un signal de commande appliqué sur ladite borne de commande.

Dans l'exemple décrit, les interrupteurs TC, T6 et T7 sont de préférence des transistors, par exemple des transistors MOSFET présentant une grille formant la borne de commande, et un drain et une source formant respectivement la première borne et la deuxième borne. Par soucis de clarté, les termes « drain », « source » et « grille » seront ainsi utilisés dans la suite de la description à la place des termes « première borne », « deuxième borne » et « borne de commande ».

Le dispositif de commande du convertisseur de tension 10 commande à l'ouverture où à la fermeture les transistors T1, T2, TC, T6 et T7 en appliquant sur leur grille un signal de commande.

Le transistor de dérivation TC est connecté à la borne d'alimentation A1 par son drain, sa source est connectée à la masse électrique, et sa borne de commande est connectée au dispositif de commande du convertisseur de tension 10.

Nous allons maintenant décrire plus avant la structure du hacheur 4.

L'inductance L du hacheur 4 est connectée par une de ses bornes à la borne d'entrée BE et par l'autre de ses bornes à la fois à la source du transistor T7 et au drain du transistor T6. D'autre part, le drain du transistor T7 est connecté à la borne de sortie BS tandis que la source du transistor T6 est connectée à la masse électrique.

La borne de sortie BS du hacheur 4 est connectée au deuxième réseau de bord. Ainsi, la capacité C2 est connectée par une de ses bornes à la borne de sortie BS et par l'autre de ses bornes à la masse électrique.

Nous allons maintenant décrire plus avant la structure du dispositif de sécurité 2.

La première borne E du dispositif de sécurité 2 est connectée au premier réseau de bord, c'est-à-dire à la première source de tension continue V1. La deuxième borne E2 du dispositif de sécurité 2 est connectée à la borne d'entrée BE du hacheur 4. La borne de commande G est connectée à la borne d'alimentation A1. La borne de commande G est destinée à recevoir un courant de commande Ig, le courant Ig étant constitué d'une partie du courant d'alimentation Ia1.

Le premier transistor de pré-charge T1 et le deuxième transistor de pré-charge T2 du dispositif de sécurité 2 sont connectés « tête-bêche ». En d'autres termes, le premier transistor de pré-charge T1 et le deuxième transistor de pré-charge T2 sont connectés par leur source S, S2. Le drain du premier transistor de pré-charge T1 est connecté à la première borne E et le drain du deuxième transistor de pré-charge T2 est connecté à la deuxième borne E2. Les grilles g1, g2 du premier T1 et du deuxième transistor T2 de pré-charge sont en outre reliées entre elles au niveau de la borne de commande G. Les transistors de pré-charge T1, T2 possèdent en outre chacun une diode intrinsèque. La cathode de la diode intrinsèque du deuxième transistor de pré-charge T2 est connectée à la deuxième borne E2 et la cathode du premier transistor de pré-charge T1 est connectée à la première borne E.

De cette façon, lorsque le premier transistor de pré-charge T1 et le deuxième transistor de pré-charge T2 sont ouverts, aucun courant ne peut s'écouler entre la première borne E et la deuxième borne E2. En effet, les diodes intrinsèques des premier et deuxième transistors de pré-charge T1, T2 sont respectivement orientées de façon à bloquer le passage du courant se dirigeant de la première borne E vers la deuxième borne E2 et bloquer le passage du courant se dirigeant de la deuxième borne E2 vers la première borne E.

La diode zener Dz est connectée par sa cathode à la borne de commande G et par son anode aux sources S, S2 des premier et deuxième transistors de pré-charge T1, T2, de telle sorte que la tension de commande Grille-Source Vgs soit inférieure ou égale à la tension de la diode zener Dz. Dans l'exemple décrit la tension zener de la diode zener Dz est de 12V. Autrement dit, la diode zener Dz permet de protéger les premier et deuxième transistors de pré-charge T1, T2 en maintenant une tension de commande Vgs inférieure ou égale à la tension maximale que peuvent supporter les premier et deuxième transistors de pré-charge T1, T2 entre leur grille et leur source.

Nous allons maintenant décrire plus avant la structure du circuit de démarrage 3.

Ce circuit de démarrage 3 comprend :

- une troisième source de tension continue V3 délivrant une tension supérieure à celle de la première source de tension V1, par exemple une tension de 36V,

- une capacité C1 qui a dans l'exemple décrit ici une valeur de l'ordre de 1μF.

- une première R1, deuxième R2, troisième R3 et quatrième R4 résistances,

- un premier interrupteur Q1 comportant une borne de commande destinée à recevoir un signal de commande permettant la commutation à l'ouverture ou à la fermeture de ce premier interrupteur Q1, cette borne de commande étant connectée électriquement par l'intermédiaire de la capacité C1 à la masse électrique, une deuxième borne connectée à la masse électrique, et une première borne connectée à la borne d'alimentation A1, et

- un deuxième interrupteur Q2 comportant une borne de commande destinée à recevoir un signal de commande permettant la commutation à l'ouverture ou à la fermeture de ce deuxième interrupteur Q2, une première borne connectée à la troisième source de tension V3 par l'intermédiaire de la deuxième résistance R2, et une deuxième borne connectée à la borne de commande du premier interrupteur Q1, et

- un troisième interrupteur Q3, comportant une borne de commande destinée à recevoir un signal de commande permettant la commutation à l'ouverture ou à la fermeture de ce troisième interrupteur Q3, une deuxième borne connectée à la masse électrique par l'intermédiaire de la quatrième résistance R4, et une première borne connectée à la borne de commande du deuxième transistor Q2 et également connectée à la troisième source de tension V3 par l'intermédiaire de la troisième résistance R3.

Dans l'exemple décrit, les interrupteurs Q1 et Q2 sont de préférence des transistors, par exemple des transistors bipolaire pnp présentant une base formant la borne de commande, et un émetteur et un collecteur formant respectivement les première et deuxième bornes. De même, l'interrupteur Q3 est de préférence un transistor, par exemple un transistor bipolaire npn présentant une base formant la borne de commande, et un émetteur et un collecteur formant respectivement les deuxième et première bornes. Par soucis de clarté, les termes « base », « émetteur » et « collecteur » seront ainsi utilisés dans la suite de la description à la place des termes « borne de commande », « première borne » et « deuxième borne ».

Ainsi, dans l'exemple de réalisation décrit ici, la troisième résistance R3 est connectée entre la source de tension continue V3 et le collecteur du troisième transistor bipolaire Q3 et la quatrième résistance R4 est connectée entre l'émetteur du troisième transistor bipolaire Q3 et la masse électrique.

La base du deuxième transistor bipolaire Q2 est connectée au collecteur du troisième transistor Q3. La deuxième résistance R2 est connectée entre la source d'alimentation V3 et l'émetteur du deuxième transistor Q2. La capacité C1 et la première résistance R1 sont connectées en série. En outre, La capacité C1 est connectée par une de ses bornes au collecteur du deuxième transistor Q2 et par l'autre de ses bornes à l'une des bornes de la première résistance R1, la première résistance R1 étant par ailleurs également connectée à la masse électrique par l'autre de ses bornes.

La base du premier transistor bipolaire Q1 est connectée au collecteur du deuxième transistor Q2. Le collecteur du premier transistor bipolaire Q1 est connecté à la masse électrique. L'émetteur du premier transistor bipolaire Q1 est connectée à la borne d'alimentation A1.

Ainsi, l'association précédemment décrite de la source de tension V3, du deuxième interrupteur Q2, du troisième interrupteur Q3 et de la deuxième résistance R2, de la troisième résistance R3 et de la quatrième résistance R4 constitue une source de courant fournissant un courant I1 à la capacité C1 lorsque la base du troisième transistor Q3 reçoit un signal de commande d'ouverture de ce troisième transistor Q3, ledit signal de commande étant par exemple émis par le dispositif de commande du convertisseur de tension 10.

Nous allons maintenant décrite le fonctionnement du dispositif de pré-charge 5.

Avant la pré-charge, l'interrupteur SW est ouvert et le transistor de dérivation TC est commandé à la fermeture par le dispositif de commande, de façon à dériver le courant d'alimentation Ia1 vers la masse électrique. Dans ce contexte, le courant de commande Ig est sensiblement nul, et les premier et deuxième transistors de pré-charge T1, T2 sont ouverts.

De même, avant le début de la précharge, le dispositif de commande du convertisseur de tension 10 commande à l'ouverture les transistors T7 et T6.

En variante, avant le début de la précharge, le dispositif de commande du convertisseur de tension 10 commande à l'ouverture le transistor T6 et à la fermeture le transistor T7.

Dans les deux cas, le hacheur 4 se comporte comme un fils électrique entre les deux transistors de pré-charge et la capacité C2 à charger.

Pour réaliser la pré-charge de la capacité C2, la borne d'alimentation A1 reçoit un courant d'alimentation Ia1 fourni par la source de courant Sa1 connectée à ladite borne d'alimentation A1.

Simultanément, le dispositif de commande applique un signal de commande d'ouverture sur la grille du transistor de commande TC et un signal de commande de fermeture sur la base du troisième transistor Q3 afin que ce dernier fonctionne dans sa zone linéaire (en anglais « active region »).

L'activation du troisième transistor Q3 a pour effet de créer un courant parcourant les résistances R3 et R4 et de faire également circuler un courant sur la base du deuxième transistor Q2 et donc de faire fonctionner le deuxième transistor Q2 dans sa zone linéaire.

Dès lors un courant circule à travers la deuxième résistance R2 et un courant constant I1 est fournie à la capacité C1.

Ainsi, l'association précédemment décrite de la source de tension continue V3, du deuxième interrupteur Q2, du troisième interrupteur Q3 et des deuxième, troisième et quatrième résistances constitue une source de courant permettant de charger la capacité C1 avec un courant I1 constant. Le courant I1 traversant la première résistance R1 crée une tension V à ses bornes, le premier transistor Q1 est alors également dans un état passant et un courant dérivé Id traverse le premier transistor Q1 de son émetteur vers la masse électrique.

Ainsi un courant dérivé Id du courant Ia1 délivré par l'alimentation Sa1 se dirige de la borne d'alimentation A1 vers l'émetteur du premier transistor Q1.

La tension de commande Vg au niveau de la borne de commande G est égale à la somme de la tension $V_{c1}$ aux bornes de la capacité C1, de la tension V aux bornes de la première résistance R1 et de la tension base-émetteur $V_{BE}$ du premier transistor Q1, tel que défini dans l'équation [Math.1] ci-dessous.

[Math.1]

$$V_g = V_{c1} + V \ \ + V_{BE}$$

La première résistance R1 est calculée de façon que, lorsque la capacité C1 est initialement déchargée (i.e. la tension $V_{c1}$ à ses bornes est nulle), la somme de la tension V et de la tension base-émetteur $V_{BE}$ du premier transistor Q1 est a minima de l'ordre de 25%, préférentiellement de 50% de la tension de seuil Vgsth du premier et du deuxième transistor de pré-charge T1,T2 nécessaire pour qu'ils entrent en conduction.

En d'autres termes, la tension V permet d'obtenir un décalage en tension au niveau de la borne de commande G du dispositif de sécurité 2 par rapport à la tension de référence 0V lorsque la capacité C1 est au début de sa charge et que la tension à ses bornes Vc1 est sensiblement nulle.

Cela a pour conséquence de réduire le temps de mise en conduction des transistors de pré-charge T1, T2 lorsque le troisième transistor Q3 reçoit un signal de commande sur sa grille.

Tant que la tension sur la borne de commande G est inférieure à la tension de seuil Vgsth des premier et deuxième transistors de pré-charge T1, T2, lesdits transistors T1, T2 sont dans un état ouvert, donc aucun courant ne circule entre la première source de tension V1 et la deuxième capacité C2. Par conséquence la tension aux niveau des sources S,S2 desdits transistors est nulle.

Au fur et à mesure que la capacité C1 se charge, la tension Vc1 à ses bornes augmente de sorte que la tension au niveau de la borne de commande G augmente de la même façon.

Lorsque la tension au niveau de la borne de commande G atteint la tension de seuil Vgsth des premier et deuxième transistors de pré-charge T1, T2, ceux-ci entrent en conduction en régime linéaire. Un courant de pré-charge I2 commence à circuler de la première source de tension V1 vers la deuxième capacité C2 en traversant l'inductance L et la diode intrinsèque du transistor T7 ce qui fait que la capacité C2 commence à être pré-chargée.

Lorsque la capacité C2 se charge, la tension aux niveau des sources S, S2 des transistors de précharge T1, T2 du dispositif de sécurité 2 augmente. Simultanément, la capacité C1 se charge et la tension au niveau de la borne de commande G augmente.

Dans le mode de réalisation décrit ici, le circuit de démarrage 3 est conçu pour que la tension de commande Vgs entre la grille et la source du premier et du deuxième transistor de pré-charge reste constante et sensiblement égale à la tension de seuil Vgsth afin de commander ces transistors de pré-charge en mode linéaire pendant toute la pré-charge de la capacité C2.

En d'autres termes, le circuit de démarrage 3 est conçu pour que la tension $V_{c2}$ aux bornes de la capacité C2 augmente graduellement en suivant la tension Vc1 aux bornes de la capacité C1 abaissée de la tension de seuil Vgsth.

Pour cela, la valeur de la capacité C1 est calculée d'après la formule [Math. 4], c'est-à-dire en fonction d'une consigne de courant de pré-charge I2 constant et prédéterminée, du courant de charge constant I1 et de la valeur de la capacité C2 à charger.

[Math.4]

$$C_1 = \frac{I_1}{I_2} \cdot C_2$$

De cette façon, les temps de charge T1, T2 des capacités C1, C2 sont sensiblement identiques et sont définis par les équations [Math.2] et [Math.3].

[Math.2]

$$T_1 = \frac{C_1 \cdot V_1}{I_1}$$

[Math.3]

$$T_1 = T_2 = \frac{C_2 \cdot V_{C2}}{I_2}$$

En d'autres termes, la capacité C2 va être charger pendant un temps de pré-charge T2=T1 jusqu'à atteindre une tension $V_{C2}$ égale à V1.

Lorsque la capacité C2 est chargé à la tension $V_{C2}$=V1, la tension au niveau de la borne de commande G sera égale à la somme de la tension de la première source de tension V1 et de la tension aux bornes de la diode zener Dz, soit dans l'exemple décrit environ 26V.

Par ailleurs, la tension aux bornes de la capacité C1 va augmenter jusqu'à atteindre sensiblement la tension de la source de tension V3, donc 36V dans l'exemple décrit ici. Par conséquence, lorsque la tension de charge $V_{c1}$ sera supérieure ou égale à la tension au niveau de la borne de commande G, le premier transistor Q1 sera dans un état bloqué, c'est-à-dire équivalent à un interrupteur ouvert.

Ainsi, le circuit de démarrage 3 est conçu pour être désactivé lorsque la tension de charge $V_{c2}$ est égale à la tension de la première source de tension V1. Le courant dérivé Id devient sensiblement nul, le courant de commande Ig qui se dirige alors vers la borne de commande G est sensiblement égale au courant d'alimentation Ia1, la tension de commande Vgs est limitée par la tension aux bornes de la diode zener Dz, et les premier et deuxième transistors T1, T2 sont alors dans un état saturé, c'est-à-dire équivalent à des interrupteurs fermés.

Enfin, lorsque la tension de charge $V_{c2}$ de la capacité C2 atteint la tension de la première source de tension V1, le circuit de commande (non représenté) du convertisseur de tension 10 permet de commander les transistors T6 et T7 du hacheur 4 de façon augmenter la tension de charge $V_{c2}$ de la capacité C2 jusqu'à atteindre la tension de la deuxième source de tension V2.

Ainsi, la connexion entre les deux réseaux électriques V1 et V2 se fera par la fermeture de l'interrupteur SW lorsque la capacité C2 sera chargée au même niveau de tension que la tension de la deuxième source de tension continue V2.

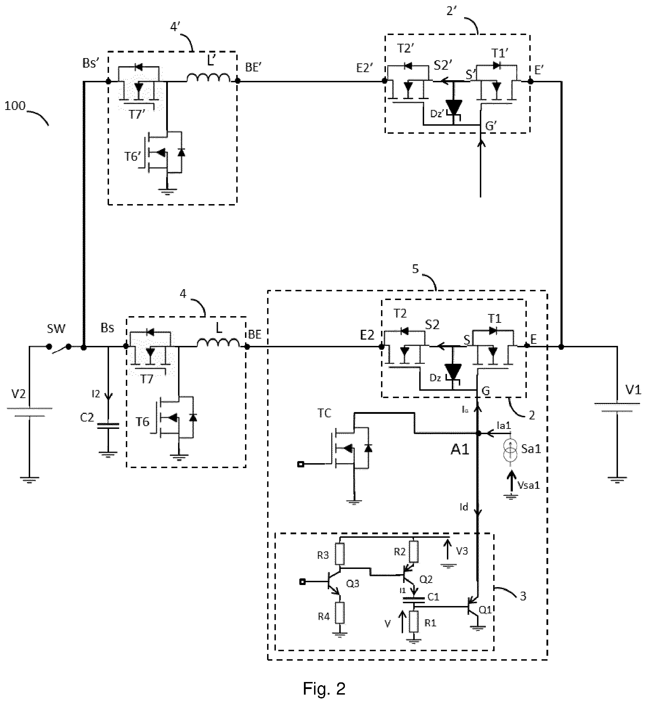

Dans le premier mode de réalisation précédemment décrit, le convertisseur de tension 10 ne comporte qu'un seul hacheur 4 en série avec un dispositif de sécurité 2. Dans un second mode de réalisation, le convertisseur de tension peut comprendre une pluralité de convertisseur élémentaires de tension connectés en parallèle, chacun des convertisseurs élémentaires de tension étant formé d'un hacheur en série avec un dispositif de sécurité. La [Figure 2] illustre ce second mode de réalisation dans le cas d'un convertisseur de tension 100 comprenant deux convertisseurs élémentaires de tension.

Par souci de simplification, des références identiques sont données sur cette [Figure 2] aux éléments communs avec le premier mode de réalisation et illustrés à la [Figure 1]. Les éléments communs au premier mode de réalisation ne seront pas décrits à nouveau.

Le convertisseur de tension 100 comprend ainsi un premier convertisseur élémentaire de tension qui n'est autre que le convertisseur de tension 10 décrit dans le premier mode de réalisation de l'invention et un second convertisseur élémentaire de tension connecté en parallèle du premier.

Plus précisément, le deuxième convertisseur élémentaire de tension comprend un hacheur 4' en série avec un dispositif de sécurité 2'.

Le hacheur 4' comprend une borne d'entrée BE', une borne de sortie BS', une inductance L', un interrupteur de hachage T6' et un interrupteur de hachage T7'.

Chaque interrupteur T6' et T7' comporte une première borne, une deuxième borne et une borne de commande destinée à sélectivement ouvrir et fermer l'interrupteur T6' et T7' en fonction d'un signal de commande appliqué sur ladite borne de commande.

Dans l'exemple décrit, les interrupteurs T6' et T7' sont de préférence des transistors, par exemple des transistors MOSFET présentant une grille formant la borne de commande, et un drain et une source formant respectivement la première borne et la deuxième borne. Par soucis de clarté, les termes « drain », « source » et « grille » seront ainsi utilisés dans la suite de la description à la place des termes « première borne », « deuxième borne » et « borne de commande ».

Le dispositif de sécurité 2' comprend une première borne E', une deuxième borne E2', une borne de commande G', un premier transistor de sécurité T1', un deuxième transistor de sécurité T2' et une diode Zener Dz'.

Dans l'exemple décrit, le premier transistor de sécurité T1' et le deuxième transistor de sécurité T2' sont de préférence des MOSFETs présentant une grille, un drain et une source.

Le dispositif de commande du convertisseur de tension 10 commande également à l'ouverture où à la fermeture les transistors T1', T2', T6' et T7' en appliquant sur leur grille un signal de commande.

L'inductance L' du hacheur 4' est connectée par une de ses bornes à la borne d'entrée BE' et par l'autre de ses bornes à la fois à la source du transistor T7' et au drain du transistor T6'. D'autre part, le drain du transistor T7' est connecté à la borne de sortie BS' tandis que la source du transistor T6' est connectée à la masse électrique.

La borne de sortie BS' du hacheur 4' est connectée à la borne de sortie BS du hacheur 4.

La première borne E' du dispositif de sécurité 2' est connectée à la première borne E (qui est également la borne d'entrée du convertisseur de tension 10) du dispositif de sécurité 2. La deuxième borne E2' du dispositif de sécurité 2' est connectée à la borne d'entrée BE' du hacheur 4. La borne de commande G' est connectée au dispositif de commande du convertisseur de tension 10.

Le premier transistor de sécurité T1 et deuxième transistor de sécurité T2' du dispositif de sécurité 2' sont connectés « tête-bêche ». En d'autres termes, le premier transistor de sécurité T1' et le deuxième transistor de sécurité T2' sont connectés par leur source S', S2'. Le drain du premier transistor de sécurité T1' est connecté à la première borne E' et le drain du deuxième transistor de sécurité T2' est connecté à la deuxième borne E2'. Les grilles g1', g2' des premier et deuxième transistor de sécurité T1', T2' sont en outre reliées entre elles au niveau de la borne de commande G'. Les transistors de sécurité T1', T2' possèdent en outre chacun une diode intrinsèque. La cathode de la diode intrinsèque du deuxième transistor de sécurité T2' est connectée à la deuxième borne E2' et la cathode du premier transistor de pré-charge T1' est connectée à la première borne E'.

De cette façon, lorsque le premier transistor de sécurité T1' et le deuxième transistor de sécurité T2' sont ouverts, aucun courant ne peut s'écouler la première borne E' et la deuxième borne E2' du dispositif de sécurité 2'.

La diode zener Dz' est connectée par sa cathode à la borne de commande G' et par son anode aux sources S', S2' des premier et deuxième transistors de sécurité T1', T2', de telle sorte que la tension de commande Grille-Source Vgs des premier et deuxième transistor de sécurité T1', T2' soit inférieure ou égale à la tension zener de la diode zener Dz'. Dans l'exemple décrit la tension de la diode zener Dz' est de 12V. Autrement dit, la diode zener Dz' permet de protéger les premier et deuxième transistors de sécurité T1', T2' en maintenant une tension de commande Vgs inférieure ou égale à la tension zener.

Nous allons maintenant décrite la pré-charge de la capacité C2. Cette pré-charge de la capacité C2 est effectuée par le dispositif de pré-charge 5 de façon analogue à la pré-charge de la capacité C2 décrite dans le premier mode de réalisation de l'invention si ce n'est qu'avant le démarrage de la pré-charge, le dispositif de commande du convertisseur de tension 10 ouvre également les interrupteurs de hachage T6' et T7'.

Enfin, et de façon optionnelle, lorsque la tension de charge $V_{c2}$ de la capacité C2 atteint la tension de la première source de tension V1, le circuit de commande du convertisseur de tension 10 peut également fermer les transistors de sécurité T1', T2' et commander les interrupteurs T6' et T7' du hacheur 4' de façon à augmenter la tension de charge $V_{c2}$ de la capacité C2 jusqu'à atteindre la tension de la deuxième source de tension V2.

La présente invention n'est pas limitée au mode de réalisation décrit précédemment. Il sera en effet apparent à l'homme du métier que des modifications des modes de réalisation précédemment décrits peuvent être apportées.

Par exemple, dans une variante de réalisation, le dispositif de sécurité 2 peut ne comporter qu'un seul transistor de pré-charge T1, et dans ce cas, la source du transistor de pré-charge T1 est connectée directement à la borne d'entrée BE du hacheur 4.

De même, dans une variante de réalisation, le circuit de démarrage 3 ne comprend pas de première résistance R1, i.e. la capacité C1 est directement connectée à la masse électrique.

## Revendications

1. Dispositif de pré-charge (5) d'une charge (C2), par exemple d'une capacité (C2) comprenant :

    a. une borne d'alimentation (A1) destinée à recevoir un courant d'activation (Ia1),

b. un premier transistor de pré-charge (T1) comprenant :

  i. une première borne (E)
  ii. une deuxième borne (S), et
  iii. une borne de commande (G) destinée à sélectivement ouvrir ou fermer ledit premier transistor de pré-charge (T1) sur réception d'un signal de commande, la première borne (E) étant destinée à être connectée à une première source de tension (V1) référencée par rapport à une masse électrique, la deuxième borne (S) étant destinée à être connectée électriquement à la charge (C2), la borne de commande (G) étant connectée à la borne d'alimentation (A1), la deuxième borne (S) fournissant un courant de pré-charge (I2) lorsque ladite deuxième borne (S) est connectée à la charge (C2), lorsque ladite première borne (E) est connectée à la première source de tension (V1) et lorsque ladite borne d'alimentation (A1) reçoit le courant d'activation (la1), et

c. un circuit de démarrage (3) connecté à la borne d'alimentation (A1), ledit circuit de démarrage (3) étant conçu pour, lorsqu'il est actif, maintenir le courant de pré-charge (I2) à une valeur constante en faisant graduellement monter la tension de la borne d'alimentation (A1), le circuit de démarrage (3) comprend en outre :

  i. une première capacité (C1),
  ii. un premier interrupteur (Q1) comprenant :

    1. une borne de commande destinée à sélectivement ouvrir ou fermer ledit premier interrupteur (Q1) sur réception d'un signal de commande, ladite borne de commande étant connectée électriquement par l'intermédiaire de la première capacité (C1) à ladite masse électrique,
    2. une deuxième borne connectée à la masse électrique,
    3. une première borne connectée à la borne d'alimentation (A1), et

  iii. une source de courant fournissant lorsqu'elle est activée un courant de charge constant (11) à ladite première capacité (C1).

2. Dispositif de pré-charge (5) d'une charge (C2) selon la revendication précédente comprenant en outre une première résistance (R1) et dans lequel la borne de commande du premier interrupteur (Q1) est directement connectée à la masse électrique par l'intermédiaire de l'association en série de ladite première capacité (C1) et de ladite première résistance (R1).

3. Dispositif de pré-charge (5) d'une charge (C2) selon la revendication 1 ou 2 dans lequel ladite source de courant comprend :

  a. une deuxième (R2), une troisième (R3) et une quatrième (R4) résistance,
  b. une deuxième source de tension continue (V3)
  c. un deuxième interrupteur (Q2) comprenant :

    i. une borne de commande destinée à sélectivement ouvrir ou fermer ledit deuxième interrupteur (Q2) sur réception d'un signal de commande,
    ii. une première borne connectée à ladite deuxième source de tension (V3) par l'intermédiaire de ladite deuxième résistance (R2),
    iii. une deuxième borne connectée à la borne de commande dudit premier interrupteur (Q1),

  d. un troisième interrupteur (Q3) comprenant :

    i. une borne de commande destinée à recevoir un signal de commande permettant la commutation à l'ouverture ou à la fermeture dudit troisième interrupteur (Q3),
    ii. une deuxième borne connectée à la masse électrique par l'intermédiaire de la quatrième résistance (R4),
    iii. une première borne connectée à la borne de commande du deuxième interrupteur (Q2) et connectée à ladite deuxième source de tension (V3) par l'intermédiaire de ladite troisième résistance (R3).

4. Dispositif de pré-charge (5) d'une charge (C2) selon l'une des revendications précédentes et comprenant en outre :

  a. un interrupteur de dérivation (TC) comprenant :

i. une borne de commande (BC) destinée à sélectivement ouvrir ou fermé ledit interrupteur de dérivation (TC) sur réception d'un signal de commande,
ii. une deuxième borne connectée à ladite masse électrique, et
iii. une première borne connectée à ladite borne d'alimentation (A1).

5. Dispositif de pré-charge (5) d'une charge (C2) selon l'une des revendications 1 à 4 dans lequel la charge est une deuxième capacité (C2) et dans lequel le quotient de l'intensité du courant de charge constant (11) fourni par ladite source de courant par le courant de pré-charge (I2) est égal au quotient de la valeur de la première capacité (C1) par la valeur de la deuxième capacité (C2).

6. Dispositif de pré-charge (5) d'une charge (C2) selon l'une des revendications précédentes comprenant en outre une diode Zener (DZ) dont la cathode est connectée électriquement à la borne de commande du premier transistor de pré-charge et dont l'anode est connectée électriquement à la deuxième borne du premier transistor de pré-charge.

7. Dispositif de pré-charge (5) d'une charge (C2) selon l'une des revendications précédentes comprenant en outre un deuxième transistor de pré-charge (T2) comprenant :

   a. une deuxième borne (S2) connectée à la deuxième borne (S) du premier transistor de pré-charge (T1),
   b. une première borne (E2) destinée à être connectée électriquement à ladite charge (C2),
   c. une borne de commande (g2) destinée à sélectivement ouvrir ou fermer ledit deuxième transistor de pré-charge (T2) et connectée à ladite borne d'alimentation (A1),

   lesdits premier et deuxième transistors de pré-charge (T1, T2) comprenant chacun une diode intrinsèque, l'anode de la diode intrinsèque de chaque transistor de pré-charge étant connectée électriquement à la deuxième borne de son transistor de pré-charge.

8. Convertisseur de tension (10) comprenant un dispositif de pré-charge (5) d'une charge (C2) selon l'une des revendications précédentes.

9. Convertisseur de tension (10) selon la revendication précédente ne comprenant qu'un seul dispositif de pré-charge (5) selon l'une des revendications 1 à 7.

## Patentansprüche

1. Vorladeeinrichtung (5) zum Vorladen einer Last (C2), zum Beispiel einer Kapazität (C2), umfassend:

   a. eine Versorgungsklemme (A1), die dazu bestimmt ist, einen Aktivierungsstrom (Ia1) zu empfangen,
   b. einen ersten Vorladetransistor (T1), umfassend:

      i. eine erste Klemme (E)
      ii. eine zweite Klemme (S), und
      iii. eine Steuerklemme (G), die dazu bestimmt ist, den ersten Vorladetransistor (T1) beim Empfangen eines Steuersignals selektiv zu öffnen oder zu schließen, wobei die erste Klemme (E) dazu bestimmt ist, an eine erste Spannungsquelle (V1) angeschlossen zu werden, die in Bezug auf eine elektrische Masse referenziert ist, wobei die zweite Klemme (S) dazu bestimmt ist, elektrisch an die Last (C2) angeschlossen zu werden, wobei die Steuerklemme (G) an die Versorgungsklemme (A1) angeschlossen ist, wobei die zweite Klemme (S) einen Vorladestrom (I2) abgibt, wenn die zweite Klemme (S) an die Last (C2) angeschlossen ist, wenn die erste Klemme (E) an die erste Spannungsquelle (V1) angeschlossen ist und wenn die Versorgungsklemme (A1) den Aktivierungsstrom (Ia1) empfängt, und

   c. eine Startschaltung (3), die an die Versorgungsklemme (A1) angeschlossen ist, wobei die Startschaltung (3) dazu ausgelegt ist, wenn sie aktiv ist, den Vorladestrom (I2) auf einem konstanten Wert zu halten, indem sie die Spannung der Versorgungsklemme (A1) stufenweise ansteigen lässt, wobei die Startschaltung (3) ferner umfasst:

      i. eine erste Kapazität (C1),
      ii. einen ersten Schalter (Q1), umfassend:

1. eine Steuerklemme, die dazu bestimmt ist, den ersten Schalter (Q1) beim Empfangen eines Steuersignals selektiv zu öffnen oder zu schließen, wobei die Steuerklemme über die erste Kapazität (C1) elektrisch an die elektrische Masse angeschlossen ist,

2. eine zweite Klemme, die an die elektrische Masse angeschlossen ist,

3. eine erste Klemme, die an die Versorgungsklemme (A1) angeschlossen ist, und

iii. eine Stromquelle, die, wenn sie aktiviert ist, einen konstanten Ladestrom (I1) an die erste Kapazität (C1) abgibt.

2. Vorladeeinrichtung (5) zum Vorladen einer Last (C2) nach dem vorhergehenden Anspruch, die ferner einen ersten Widerstand (R1) umfasst und bei der die Steuerklemme des ersten Schalters (Q1) über die Reihenschaltung der ersten Kapazität (C1) und des ersten Widerstands (R1) direkt an die elektrische Masse angeschlossen ist.

3. Vorladeeinrichtung (5) zum Vorladen einer Last (C2) nach Anspruch 1 oder 2, bei der die Stromquelle umfasst:

a. einen zweiten (R2), einen dritten (R3) und einen vierten (R4) Widerstand,
b. eine zweite Gleichspannungsquelle (V3)
c. einen zweiten Schalter (Q2), umfassend:

i. eine Steuerklemme, die dazu bestimmt ist, den zweiten Schalter (Q2) beim Empfangen eines Steuersignals selektiv zu öffnen oder zu schließen,
ii. eine erste Klemme, die an die zweite Spannungsquelle (V3) über den zweiten Widerstand (R2) angeschlossen ist,
iii. eine zweite Klemme, die an die Steuerklemme des ersten Schalters (Q1) angeschlossen ist,

d. einen dritten Schalter (Q3), umfassend:

i. eine Steuerklemme, die dazu bestimmt ist, ein Steuersignal zu empfangen, das das Umschalten des dritten Schalters (Q3) auf Öffnen oder auf Schließen ermöglicht,
ii. eine zweite Klemme, die über den vierten Widerstand (R4) an die elektrische Masse angeschlossen ist,
iii. eine erste Klemme, die an die Steuerklemme des zweiten Schalters (Q2) angeschlossen ist und an die zweite Spannungsquelle (V3) über den dritten Widerstand (R3) angeschlossen ist.

4. Vorladeeinrichtung (5) zum Vorladen einer Last (C2) nach einem der vorhergehenden Ansprüche und umfassend ferner:

a. einen Abzweigschalter (TC), umfassend:

i. eine Steuerklemme (BC), die dazu bestimmt ist, den Abzweigschalter (TC) beim Empfangen eines Steuersignals selektiv zu öffnen oder zu schließen,
ii. eine zweite Klemme, die an die elektrische Masse angeschlossen ist, und
iii. eine erste Klemme, die an die Versorgungsklemme (A1) angeschlossen ist.

5. Vorladeeinrichtung (5) zum Vorladen einer Last (C2) nach einem der Ansprüche 1 bis 4, bei der die Last eine zweite Kapazität (C2) ist und bei der der Quotient aus der Intensität des von der Stromquelle abgegebenen konstanten Ladestroms (I1) und aus dem Vorladestrom (I2) gleich dem Quotienten aus dem Wert der ersten Kapazität (C1) und aus dem Wert der zweiten Kapazität (C2) ist.

6. Vorladeeinrichtung (5) zum Vorladen einer Last (C2) nach einem der vorhergehenden Ansprüche, umfassend ferner eine Zener-Diode (DZ), deren Kathode elektrisch an die Steuerklemme des ersten Vorladetransistors angeschlossen ist und deren Anode elektrisch an die zweite Klemme des ersten Vorladetransistors angeschlossen ist.

7. Vorladeeinrichtung (5) zum Vorladen einer Last (C2) nach einem der vorhergehenden Ansprüche, umfassend ferner einen zweiten Vorladetransistor (T2), umfassend:

a. eine zweite Klemme (S2), die an die zweite Klemme (S) des ersten Vorladetransistors (T1) angeschlossen ist,
b. eine erste Klemme (E2), die dazu bestimmt ist, elektrisch an die Last (C2) angeschlossen zu werden,
c. eine Steuerklemme (g2), die dazu bestimmt ist, den zweiten Vorladetransistor (T2) selektiv zu öffnen oder zu schließen, und an die Versorgungsklemme (A1) angeschlossen ist,

wobei die ersten und zweiten Vorladetransistoren (T1, T2) jeweils eine intrinsische Diode umfasst, wobei die Anode der intrinsischen Diode jedes Vorladetransistors elektrisch an die zweite Klemme ihres Vorladetransistors angeschlossen ist.

8. Spannungswandler (10), umfassend eine Vorladeeinrichtung (5) zum Vorladen einer Last (C2) nach einem der vorhergehenden Ansprüche.

9. Spannungswandler (10) nach dem vorhergehenden Anspruch, umfassend nur eine einzige Vorladeeinrichtung (5) nach einem der Ansprüche 1 bis 7.

**Claims**

1. Device (5) for pre-charging a charge (C2), for example a capacitor (C2), comprising:

   a. a power supply terminal (A1) intended to receive an activation current (Ia1),
   b. a first pre-charging transistor (T1) comprising:

      i. a first terminal (E),
      ii. a second terminal (S), and
      iii. a control terminal (G) intended to selectively open or close said first pre-charging transistor (T1) upon receipt of a control signal, the first terminal (E) being intended to be connected to a first voltage source (V1) referenced relative to an electrical ground, the second terminal (S) being intended to be electrically connected to the charge (C2), the control terminal (G) being connected to the power supply terminal (A1), the second terminal (S) supplying a pre-charging current (I2) when said second terminal (S) is connected to the charge (C2), when said first terminal (E) is connected to the first voltage source (V1) and when said power supply terminal (A1) receives the activation current (Ia1), and

   c. a starting circuit (3) connected to the power supply terminal (A1), said starting circuit (3) being designed, when it is active, to keep the pre-charging current (I2) at a constant value while gradually increasing the voltage of the power supply terminal (A1), the starting circuit (3) further comprising:

      i. a first capacitor (C1),
      ii. a first switch (Q1) comprising:

         1. a control terminal intended to selectively open or close said first switch (Q1) upon receipt of a control signal, said control terminal being electrically connected via the first capacitor (C1) to said electrical ground,
         2. a second terminal connected to the electrical ground,
         3. a first terminal connected to the power supply terminal (A1), and

      iii. a current source which, when activated, supplies said first capacitor (C1) with a constant charging current (I1).

2. Device (5) for pre-charging a charge (C2) according to the preceding claim, further comprising a first resistor (R1) and wherein the control terminal of the first switch (Q1) is directly connected to the electrical ground via the series connection of said first capacitor (C1) and said first resistor (R1).

3. Device (5) for pre-charging a charge (C2) according to Claim 1 or 2, wherein said current source comprises:

   a. a second (R2), a third (R3) and a fourth (R4) resistor,
   b. a second DC voltage source (V3),
   c. a second switch (Q2) comprising:

      i. a control terminal intended to selectively open or close said second switch (Q2) upon receipt of a control signal,

**15**

ii. a first terminal connected to said second voltage source (V3) via said second resistor (R2),
iii. a second terminal connected to the control terminal of said first switch (Q1),

d. a third switch (Q3) comprising:

i. a control terminal intended to receive a control signal allowing said third switch (Q3) to switch to open or closed,
ii. a second terminal connected to the electrical ground via the fourth resistor (R4),
iii. a first terminal connected to the control terminal of the second switch (Q2) and connected to said second voltage source (V3) via said third resistor (R3).

4. Device (5) for pre-charging a charge (C2) according to one of the preceding claims and further comprising:

a. a bypass switch (TC) comprising:

i. a control terminal (BC) intended to selectively open or close said bypass switch (TC) upon receipt of a control signal,
ii. a second terminal connected to said electrical ground, and
iii. a first terminal connected to said power supply terminal (A1).

5. Device (5) for pre-charging a charge (C2) according to one of Claims 1 to 4, wherein the charge is a second capacitor (C2) and wherein the quotient of the intensity of the constant charging current (I1) supplied by said current source divided by the pre-charging current (I2) is equal to the quotient of the value of the first capacitor (C1) divided by the value of the second capacitor (C2).

6. Device (5) for pre-charging a charge (C2) according to one of the preceding claims, further comprising a Zener diode (DZ), the cathode of which is electrically connected to the control terminal of the first pre-charging transistor and the anode of which is electrically connected to the second terminal of the first pre-charging transistor.

7. Device (5) for pre-charging a charge (C2) according to one of the preceding claims, further comprising a second pre-charging transistor (T2) comprising:

a. a second terminal (S2) connected to the second terminal (S) of the first pre-charging transistor (T1),
b. a first terminal (E2) intended to be electrically connected to said charge (C2),
c. a control terminal (g2) intended to selectively open or close said second pre-charging transistor (T2) and connected to said power supply terminal (A1),

said first and second pre-charging transistors (T1, T2) each comprising an intrinsic diode, with the anode of the intrinsic diode of each pre-charging transistor being electrically connected to the second terminal of its pre-charging transistor.

8. Voltage converter (10) comprising a device (5) for pre-charging a charge (C2) according to one of the preceding claims.

9. Voltage converter (10) according to the preceding claim, comprising only one pre-charging device (5) according to one of Claims 1 to 7.

Fig. 1

Fig. 2

**EP 4 085 529 B1**

## RÉFÉRENCES CITÉES DANS LA DESCRIPTION

**Documents brevets cités dans la description**

- US 2018316279 A

- FR 2984623